# EUROPEAN PATENT APPLICATION

(11) **EP 4 651 688 A1**
(43) Date of publication of application: **19.11.2025**
(21) Application number: 24741583.9
(22) Date of filing: 12.01.2024
(51) Int. Cl.: H10K 50/842, B32B 7/023, H10K 30/50, H10K 30/60, H10K 30/80, H10K 50/844, H10K 71/00, H10K 77/10

(54) **DEVICE AND METHOD FOR MANUFACTURING DEVICE**

(30) Priority: 13.01.2023 JP 2023004043
(71) Applicant: Toyobo Co., Ltd., Kita-ku Osaka-shi, Osaka 530-0001 (JP)
(72) Inventor: OKUYAMA, Tetsuo, Otsu-shi, Shiga 520-0292 (JP); TOKUDA, Kaya, Otsu-shi, Shiga 520-0292 (JP); MATSUO, Keisuke, Otsu-shi, Shiga 520-0292 (JP)
(74) Representative: Vossius & Partner Patentanwälte Rechtsanwälte mbB
(86) International application number: PCT/JP2024/000552
(87) International publication number: WO 2024/150811

(57) **Abstract**

An object of the present invention is to provide a device and the like that can suppress occurrence of a smear and peeling off of a layer when a laminated structure including a substrate, a protective layer, and an adhesive agent layer between the substrate and the protective layer is cut by ultraviolet light. The present invention relates to a device 10, etc. that has a substrate 14, a protective layer 11, and an adhesive agent layer 15 located on the protective layer 11, between the substrate 14 and the protective layer 11, and in which the ultraviolet transmittance of the adhesive agent layer 15 is 30% or lower on wavelength of 355 nm.

## Description

### TECHNICAL FIELD

The present invention relates to a device and a method for manufacturing the device.

### BACKGROUND ART

It has been known that a predetermined layer or a predetermined laminated body is cut through irradiation with light during production of a device (Patent Literatures 1 to 4).

Patent Literature 1 discloses that a laminated body in which an element substrate, a lower electrode, and a protective layer are laminated is subjected to laser machining, and the lower electrode is laser-scribed.

Patent Literature 2 describes that a dicing adhesive sheet having a substrate and an adhesive agent layer provided on the substrate is attached to a semiconductor wafer on which a low dielectric material layer is formed, and the low dielectric material layer is cut through irradiation with laser.

Patent Literature 3 teaches that a surface of a substrate and an adhesive agent layer of an adhesive tape are attached to each other, and a substrate is subjected to laser machining.

Patent Literature 4 describes that a laminated film composed of a heat-resistant polymer film and a protective film formed on both surfaces thereof is irradiated with ultraviolet laser, to cut the protective film and the heat-resistant polymer film, and the resultant cut product is attached to an inorganic substrate.

### CITATION LIST

### PATENT LITERATURE

| | |
|---|---|
| [Patent Literature 1] | Japanese Laid-Open Patent Publication No. 2014-49518 |
| [Patent Literature 2] | Japanese Laid-Open Patent Publication No. 2013-21105 |
| [Patent Literature 3] | Japanese Laid-Open Patent Publication No. 2015-21065 |
| [Patent Literature 4] | Japanese Laid-Open Patent Publication No. 2020-100026 |

### SUMMARY OF THE INVENTION

### PROBLEMS TO BE SOLVED BY THE INVENTION

As described above, the technologies of Patent Literatures 1 to 4 are patterning or cutting realized by light irradiation at the stage of production of a device. However, it is also desired that a device obtained by attaching a protective layer such as a gas barrier film onto a substrate and a laminated body produced on the substrate (the substrate and the laminated body are also collectively referred to as a structure) is subjected to light irradiation to perform cutting, thereby efficiently producing the aimed device.

For example, when a lamination structure composed of a plurality of layers whose materials are different from each other is subjected to light irradiation to be cut, the cutting behavior is different between the respective materials. Thus, a smear (e.g., black matter caused by light irradiation), and/or accumulation of gas generated in the inner layer (further, generation of bubbles due to the gas accumulation) can occur due to the fact that the cutting starts at an inner layer. Further, when there is a layer including a gas barrier material, particularly, when a laminated body is sandwiched by a glass substrate and a gas barrier film in the lamination structure, the generated gas cannot escape, and as a result, peeling off of another layer may also be caused.

Therefore, an object of the present invention is to provide a device and a method for manufacturing the device that can suppress occurrence of a smear and peeling off of layers when a lamination structure including a substrate, a protective layer, and an adhesive agent layer between the substrate and the protective layer is cut by ultraviolet light.

### SOLUTION TO THE PROBLEMS

When ultraviolet light laser is used, precise cutting is enabled but the cutting starts from an inner layer of the lamination structure, and thus, there is a problem of occurrence of a smear and peeling off of a layer, as described above. As a solution to this problem, we have found that the ultraviolet transmittance of the adhesive agent layer provided to the protective layer can be controlled. The present invention having attained the above object has the following points as summary.

A device of the present invention comprises a substrate, a protective layer, an adhesive agent layer interposed between the substrate and the protective layer, wherein the adhesive agent layer is located on the protective layer, and
the adhesive agent layer has an ultraviolet transmittance of 30% or less at a wavelength of 355 nm.

The protective layer preferably has an ultraviolet transmittance of 70% or less at a wavelength of 355 nm.

The difference between the ultraviolet transmittance of the adhesive agent layer and the ultraviolet transmittance of the protective layer is preferably 13% or less.

The adhesive agent layer preferably comprises at least one selected from an epoxy adhesive and a urethane adhesive.

The adhesive agent layer is preferably an adhesive agent layer which is curable at room temperature or by heat, and the adhesive agent layer preferably further comprises an ultraviolet absorber.

The device of the present invention is preferably a device is for cutting with ultraviolet light.

Another embodiment of the present invention encompasses a method for manufacturing a device, comprising steps of:
forming a structure body comprising a substrate, a first laminated body on a first region of the substrate, and a second laminated body on a second region different from the first region of the substrate,
adhering a protective layer arranged with an adhesive agent layer having an ultraviolet transmittance of 30% or less at a wavelength of 355 nm over the structure body of the first laminated body and the second laminated body through the adhesive agent layer, and
irradiating ultraviolet light into a third region between the first laminated body and the second laminated body of the structure body to melt a portion present in the third region of the substrate, the adhesive agent layer, and the protective layer.

In the method for manufacturing the device of the present invention, the first laminated body includes a first electron transport layer, a first hole transport layer, and a first active layer between the first electron transport layer and the first hole transport layer, and the second laminated body includes a second electron transport layer, a second hole transport layer, and a second active layer between the second electron transport layer and the second hole transport layer.

In the method for manufacturing the device of the present invention, the substrate is in contact with the adhesive agent layer in the third region. In some cases, electrical wiring may be provided between the substrate and the adhesive agent layer.

### ADVANTAGEOUS EFFECTS OF THE INVENTION

According to the present invention, it is possible to provide a device and a method for manufacturing the device that can suppress occurrence of a smear and peeling off of a layer when a structure including a substrate, a protective layer, and an adhesive agent layer between the substrate and the protective layer is cut by ultraviolet light.

In addition, according to the present invention, the device can be efficiently divided and can be caused to have good cut portions and good power generation characteristics after storage. For example, since laminated bodies to be respectively used in a plurality of devices are collectively produced on a single substrate, and then the resultant product is divided as described above, the present invention is advantageous in both of production efficiency and manufacturing cost when producing another device such as a display device, a sensor, and an input device other than a solar cell. Further, since the protective layer (protective film) is provided at the time of the above-mentioned cutting, the risk of damaging the device during cutting is also reduced.

### BRIEF DESCRIPTION OF THE DRAWINGS

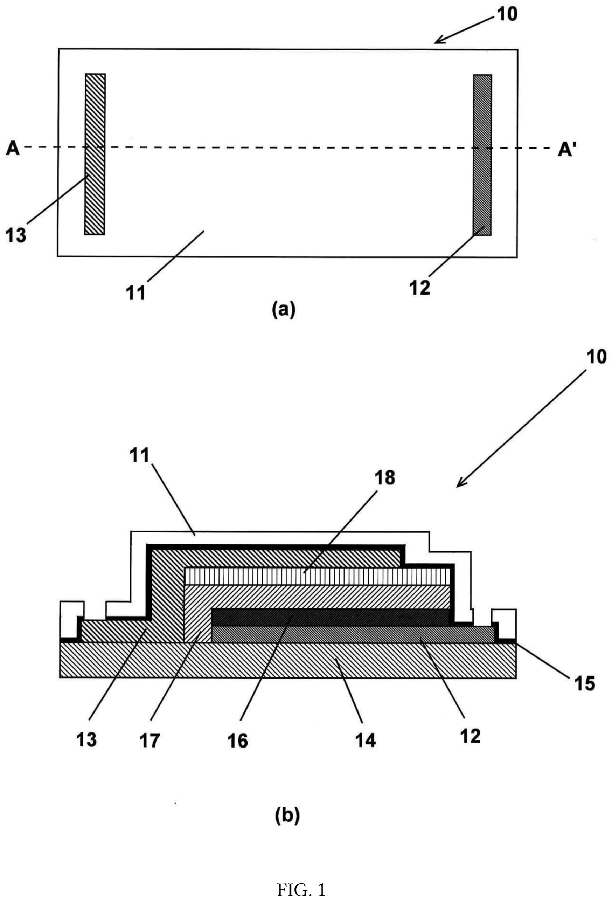

[FIG. 1] FIG. 1(a) is a top view of a device according to an embodiment of the present invention, and FIG. 1(b) is a cross-sectional view of the device corresponding to a dotted line A-A' in FIG. 1(a).

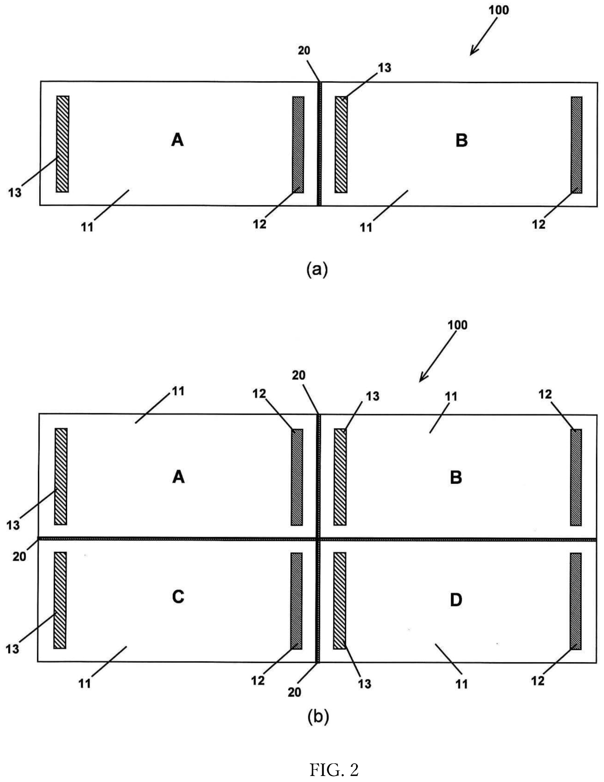

[FIG. 2] FIG. 2(a) is a top view of the device after a protective layer is adhered, via an adhesive agent layer, over a first laminated body on a first region and a second laminated body on a second region in a method for manufacturing the device according to an embodiment of the present invention. FIG. 2(b) is a top view of the device after a protective layer is adhered, via the adhesive agent layer, over respective laminated bodies on the first region, the second region, a fourth region, and a fifth region in the method for manufacturing the device according to another embodiment of the present invention.

### DESCRIPTION OF EMBODIMENTS

Hereinafter, the present invention will be specifically described based on the embodiments below. However, the present invention is not limited to the embodiments below. It is needless to say that the present invention can be appropriately modified and implemented without departing from the gist described above and below, and such modifications are included in the technological scope of the present invention. In the figures, for convenience, hatching, reference characters of components, or the like may be omitted. However, in such a case, the description or other figures are to be referred to. Dimensions of various components in the figures may be different from actual dimensions in order to place a higher priority to easy understanding of the features of the present invention.

### 1. Device

With reference to FIGS. 1(a) and 1(b), a basic configuration of a device will be described. FIG. 1(a) shows a top view of the device according to an embodiment of the present invention, and FIG. 1(b) shows a cross-sectional view of the device corresponding to a dotted line A-A' in FIG. 1(a).

As shown in FIG. 1(a), a device 10 of the present invention is obtained by covering a substrate and the like by a protective layer 11, and preferably, openings are provided in parts of the protective layer 11, and in the openings, a transparent electrically-conductive layer 12 and an electrically-conductive layer 13 are exposed. When the openings are provided, a current can be extracted.

As shown in FIG. 1(b), the device 10 of the present invention is the device 10 comprising a substrate 14, the protective layer 11, and an adhesive agent layer 15 interposed between the substrate 14 and the protective layer 11, wherein the adhesive agent layer 15 is located on the protective layer 14. The ultraviolet transmittance (wavelength: 355 nm) of the adhesive agent layer 15 is 30% or lower. Preferably, the adhesive agent layer 15 is in contact with the protective layer 11, but as long as the effect of the present invention is not affected, another layer may be present between the adhesive agent layer 15 and the protective layer 11.

In the present invention, even if the device 10 has not only the substrate 14, the protective layer 11, and the adhesive agent layer 15, but also a structure (e.g., a lamination structure that enables photoelectric conversion) other than these, the device 10 can be efficiently divided by melting (cutting) a part composed of the substrate 14, the protective layer 11, and the adhesive agent layer 15 through ultraviolet irradiation.

The ultraviolet transmittance (wavelength: 355 nm) of the adhesive agent layer 15 is 30% or lower, preferably 29% or lower, more preferably 28% or lower, and further preferably 27% or lower, and preferably 1% or higher or 2% or higher, and more preferably 5% or higher, or may be 10% or higher. When the transmittance is in the above range, cutting characteristics due to ultraviolet light of the substrate 14, the protective layer 11, and the adhesive agent layer 15 become good, the deterioration region caused by ultraviolet irradiation is small, and storage characteristics can also be made good. When the transmittance is higher than 30%, the cutting characteristics due to ultraviolet light of the substrate 14, the protective layer 11, and the adhesive agent layer 15 are not sufficient, the deterioration region caused by ultraviolet irradiation becomes large, and the storage characteristics may fail to be sufficient, either.

For example, the ultraviolet transmittance of the adhesive agent layer 15 can be obtained by measuring a linear transmission component by using an ultraviolet and visible spectrophotometer (e.g., UV3600 manufactured by SHIMADZU CORPORATION).

Examples of the adhesive agent forming the adhesive agent layer 15 include acrylic adhesive agents, rubber adhesive agents, silicone adhesive agents, polyester adhesive agents, polyurethane adhesive agents, polyamide adhesive agents, epoxy adhesive agents, vinyl alkyl ether adhesive agents, fluorine adhesive agents, and the like. The adhesive agents can be used individually or in combination of two types or more.

Among them, from the viewpoint of adhesiveness with the protective layer and the substrate and melting due to ultraviolet light, it is preferable that the adhesive agent is at least one selected from an epoxy adhesive agent and a urethane adhesive agent.

From the viewpoint of adhesiveness, preferably, the adhesive agent contains a hydroxy group, and preferably, the hydroxy group-containing adhesive agent is a hydroxy group-containing acrylic adhesive agent, a hydroxy group-containing polyester adhesive agent, a hydroxy group-containing polyurethane adhesive agent, or a hydroxy group-containing fluorine adhesive agent (hereinafter, these will be collectively referred to as an adhesive agent component (A)).

The hydroxy group-containing acrylic adhesive agent may be any acrylic resin that can be obtained by polymerizing a hydroxy group-containing acrylic ester or a hydroxy group-containing methacrylic acid ester as an essential component. In the following, acrylic and methacrylic will be collectively referred to as (meth)acrylic.

For example, an acrylic resin can be easily manufactured by copolymerizing a carboxylic acid group-containing monomer such as (meth)acrylic acid, itaconic acid, or maleic anhydride, while using a (meth)acrylic ester as an essential component. Examples of the (meth)acrylic ester include methyl(meth)acrylate, ethyl(meth)acrylate, propyl(meth)acrylate, isopropyl(meth)acrylate, butyl(meth)acrylate, isobutyl(meth)acrylate, tert-butyl(meth)acrylate, lauryl(meth)acrylate, stearyl(meth)acrylate, 2-ethylhexyl(meth)acrylate, cyclohexyl(meth)acrylate, methylcyclohexyl(meth)acrylate, cyclododecyl(meth)acrylate, isobornyl(meth)acrylate, and the like.

As a copolymerization component with the (meth)acrylic ester, for example, when a hydroxy group-containing (meth)acrylic ester such as hydroxyethyl(meth)acrylate, hydroxypropyl(meth)acrylate, or hydroxybutyl(meth)acrylate is used in combination, a hydroxy group-containing (meth)acrylic resin in which a hydroxy group is introduced in a side chain of the acrylic resin skeleton can be obtained.

The hydroxy group-containing acrylic adhesive agent is a methacrylic acid ester resin obtained by copolymerizing methyl methacrylate and 2-hydroxyethyl methacrylate, for example, and may be ACRYDIC A-808-T (DIC Corporation) or the like as a commercial item.

The hydroxy group-containing polyester adhesive agent may be any polyester resin obtained by reacting, as essential components, a glycol and a dibasic acid or a derivative thereof. Instead of the above dibasic acid, by using a dibasic acid anhydride, or an ester-forming derivative such as a dibasic acid lower alkyl ester, it is also possible to obtain a polyester resin not only through polycondensation reaction but also through addition reaction or transesterification.

Examples of the polyester resin include: an aliphatic polyester resin obtained by reacting, as essential raw material components, an aliphatic glycol such as ethylene glycol, propylene glycol, butanediol, pentanediol, hexanediol, heptanediol, decanediol, or cyclohexanedimethanol, and an aliphatic dibasic acid such as succinic acid, adipic acid, sebacic acid, fumaric acid, suberic acid, azelaic acid, 1,10-decamethylenedicarboxylic acid, or cyclohexanedicarboxylic acid; and an aromatic polyester resin obtained by reacting, as essential raw material components, an aliphatic glycol such as ethylene glycol, propylene glycol, or butanediol and an aromatic dibasic acid such as terephthalic acid, isophthalic acid, or naphthalenedicarboxylic acid.

The hydroxy group-containing polyurethane adhesive agent may be any polyurethane resin obtained by reacting a polyisocyanate compound and a compound that contains at least two hydroxy groups in one molecule, at a ratio in which the hydroxy groups are in an excessive amount relative to the isocyanate groups.

Examples of the polyisocyanate compound include hexamethylene diisocyanate, toluene diisocyanate, m-xylylene diisocyanate, isophorone diisocyanate, and the like. Examples of the compound that contains at least two hydroxy groups in one molecule include polyhydric alcohols (e.g., glycerin), polyester diol, polyethylene glycol, polypropylene glycol, polycarbonate diol, and the like.

The hydroxy group-containing fluorine adhesive agent may be any hydroxy group-containing fluorine resin obtained by polymerizing a fluorine vinyl monomer as an essential component.

Examples of the above fluorine vinyl monomers include: fluoroolefins such as vinyl fluoride, vinylidene fluoride, tetrafluoroethylene, hexafluoropropylene, 1,1,3,3,3-pentafluoropropylene, 2,2,3,3-tetrafluoropropylene, 1,1,2-trifluoropropylene, or 3,3,3-trifluoropropylene; and further, fluoroolefins that contains a halogen atom other than a fluorine atom such as chlorotrifluoroethylene, bromotrifluoroethylene, 1-chloro-1,2-difluoroethylene, or 1,1-dichloro-2,2-difluoroethylene.

Further, as the copolymerization component with a fluorine resin, for example, when a hydroxy group-containing (meth)acrylic ester such as hydroxyethyl(meth)acrylate, hydroxypropyl(meth)acrylate, or hydroxybutyl(meth)acrylate, or a hydroxy group-containing vinyl ether such as 2-hydroxyethylvinyl ether, diethylene glycol monovinyl ether, or 4-hydroxybutylvinyl ether is used in combination, a hydroxy group-containing fluorine resin in which a hydroxy group is introduced in a side chain of the fluorine resin skeleton can be obtained.

In order to form a coating film excellent in adhesiveness on the substrate, the adhesive agent component (A) preferably satisfies a glass transition temperature of 20 to 110°C, more preferably satisfies a glass transition temperature of 40 to 100°C, and further preferably satisfies a glass transition temperature of 60 to 80°C.

For example, the glass transition temperature can be obtained according to JIS K7121.

The adhesive agent component (A) preferably has a hydroxyl value of 1 mg KOH/g or more and less than 80 mg KOH/g, more preferably has a hydroxyl value of 2 mg KOH/g or more and 70 mg KOH/g or less, and further preferably has a hydroxyl value of 5 mg KOH/g or more and 60 mg KOH/g or less. For example, the hydroxyl value can be obtained according to JIS K1557-1.

The adhesive agent component (A) preferably satisfies an average molecular weight of 5000 to 100000, more preferably satisfies an average molecular weight of 10000 to 80000, and further preferably satisfies an average molecular weight of 20000 to 60000. Preferably, the average molecular weight is the number average molecular weight.

The adhesive agent may include an adhesive agent component (B) in addition to the adhesive agent component (A), and the adhesive agent component (B) has a molecular weight smaller than the average molecular weight of the adhesive agent component (A) or a hydroxyl value larger than that of the adhesive agent component (A).

Examples of the adhesive agent component (B) include one type or more of resins and the like selected from the group consisting of acrylic polyols, polyether polyols, polyester polyols, polyolefin polyols, polycarbonate polyols, urethane polyols, and fluorine polyols. The adhesive agent component (B) preferably is a polycarbonate polyol, and more preferably a polycarbonate diol.

The hydroxyl value of the adhesive agent component (B) is preferably more than 80 mg KOH/g and 500 mg KOH/g or less, more preferably 90 mg KOH/g or more and 400 mg KOH/g or less, and further preferably 100 mg KOH/g or more and 300 mg KOH/g or less.

The average molecular weight of the adhesive agent component (B) is preferably 200 or more and less than 5000, more preferably 250 or more and 4000 or less, and further preferably 400 or more and 3000 or less. Preferably, the average molecular weight is the number average molecular weight.

As the blending ratio between the adhesive agent component (A) and the adhesive agent component (B), it is preferable to blend 1 to 50 parts by weight of the adhesive agent component (B) with respect to 100 parts by weight of the adhesive agent component (A) in the viewpoint of the increased adhesive agent strength.

Other than the adhesive agent component (A) and the adhesive agent component (B), a polyisocyanate compound (C) may be used.

An example of the polyisocyanate compound (C) is an organic compound having at least two isocyanate groups in a molecule. Examples of the organic polyisocyanate compound include polyisocyanates such as tolylene diisocyanate, xylylene diisocyanate, diphenylmethane diisocyanate, 1,6-hexamethylene diisocyanate, isophorone diisocyanate, 4,4'-methylenebis(cyclohexylisocyanate), lysine diisocyanate, trimethylhexamethylene diisocyanate, 1,3-(isocyanatomethyl)cyclohexane, 1,5-naphthalenediisocyanate, and triphenylmethane triisocyanate; and derivatives (modified products) of polyisocyanates such as adducts of these polyisocyanates, biurets of these polyisocyanates, or isocyanurates of these polyisocyanates.

The polyisocyanate compound (C) may be selected as appropriate according to the usage thereof, and when a more excellent weather resistance is required, an aliphatic-based or alicyclic non-yellowing-type polyisocyanate, for example, is preferably used. Preferably, a non-yellowing-type polyisocyanate such as hexamethylene diisocyanate (HDI) or isophorone diisocyanate (IPDI) is used.

The weight proportion between the hydroxy group-containing adhesive component (A) and/or (B) and the polyisocyanate compound as a curing agent will differ depending on the types of the main agent and the curing agent to be used, the content of functional groups, and the like. However, when the total of the weight conversions of both is defined as 100%, the use proportion of the curing agent is usually 0.1 to 30%, and preferably 1 to 20%, in particular.

Further, the polyisocyanate compound is blended such that, with respect to the hydroxy group of the hydroxy group-containing resin, the isocyanate group in the polyisocyanate compound has preferably a 0.5 to 10.0 equivalent weight, and more preferably a 0.8 to 5.0 equivalent weight.

An epoxy resin (D) may be added to the adhesive agent. Examples of the epoxy resin include: bisphenol-type epoxy resins such as bisphenol A-type epoxy resins, bisphenol F-type epoxy resins, bisphenol S-type epoxy resins, and bisphenol AD-type epoxy resins; ortho-cresol novolac-type epoxy resins, phenol novolac-type epoxy resins, naphthol novolac-type epoxy resins, bisphenol A novolac-type epoxy resins, brominated phenol novolac-type epoxy resins, and alkylphenol novolac-type epoxy resins; and the like. The epoxy compounds may be used individually, or two types or more of the epoxy compounds may be mixed.

A mixture of: one type or more selected from the adhesive agent component (A), the adhesive agent component (B), and the polyisocyanate compound (C); and the epoxy resin (D) may be regarded as an epoxy adhesive agent.

The epoxy resin may have a predetermined epoxy equivalent weight, and the epoxy equivalent weight is preferably 100 to 400 g/eq, more preferably 150 to 350 g/eq, and further preferably 200 to 300 g/eq. For example, the epoxy equivalent weight can be obtained according to JIS K7236.

The adhesive agent is preferably a combination of the hydroxy group-containing acrylic adhesive agent (preferably, a copolymer of methyl methacrylate and 2-hydroxyethyl methacrylate) as the adhesive agent component (A), and the polyisocyanate compound (C) (preferably, hexamethylene diisocyanate), and is preferably a combination of the hydroxy group-containing acrylic adhesive agent as the adhesive agent component (A), polycarbonate diol as the adhesive agent component (B), the polyisocyanate compound (C) (hexamethylene diisocyanate), and the epoxy resin (D) (preferably, a bisphenol A-type epoxy resin).

From the viewpoint of viscosity adjustment, an organic solvent may be added to the above-described components. Specifically, examples thereof include: hydrocarbon solvents such as toluene and xylene; ketone solvents such as methyl ethyl ketone and methyl isobutyl ketone; ester solvents such as ethyl acetate and butyl acetate; ether solvents such as dioxane and ethylene glycol diethyl ether; aliphatic hydrocarbons such as pentane, hexane, and heptane; and the like.

From the viewpoint of satisfying the above-described ultraviolet transmittance, the adhesive agent layer 15 preferably includes an ultraviolet absorber.

As the ultraviolet absorber, a known ultraviolet absorber can be used. Examples of the ultraviolet absorber include organic ultraviolet absorbers and inorganic ultraviolet absorbers, but from the viewpoint of transparency, an organic ultraviolet absorber is preferable.

Examples of the organic ultraviolet absorber include benzotriazole ultraviolet absorbers, benzophenone ultraviolet absorbers, or cyclic imino ester ultraviolet absorbers, and combinations thereof.

Examples of the benzotriazole ultraviolet absorber include 2-[2'-hydroxy-5'-(methacryloyloxymethyl)phenyl]-2H-benzotriazole, 2-[2'-hydroxy-5'-(methacryloyloxyethyl)phenyl]-2H-benzotriazole, 2-[2'-hydroxy-5'-(methacryloyloxypropyl)phenyl]-2H-benzotriazole, 2-[2'-hydroxy-5'-(methacryloyloxyhexyl)phenyl]-2H-benzotriazole, 2-[2'-hydroxy-3'-tert-butyl-5'-(methacryloyloxyethyl)phenyl]-2H-benzotriazole, 2-[2'-hydroxy-5'-tert-butyl-3'-(methacryloyloxyethyl)phenyl]-2H-benzotriazole, 2-[2'-hydroxy-5'-(methacryloyloxyethyl)phenyl]-5-chloro-2H-benzotriazole, 2-[2'-hydroxy-5'-(methacryloyloxyethyl)phenyl]-5-methoxy-2H-benzotriazole, 2-[2'-hydroxy-5'-(methacryloyloxyethyl)phenyl]-5-cyano-2H-benzotriazole, 2-[2'-hydroxy-5'-(methacryloyloxyethyl)phenyl]-5-tert-butyl-2H-benzotriazole, 2-[2'-hydroxy-5'-(methacryloyloxyethyl)phenyl]-5-nitro-2H-benzotriazole, 2-(3,5-di-tert-amyl-2-hydroxyphenyl)-2H-benzotriazole, and the like.

Examples of the benzophenone ultraviolet absorber include 2,2',4,4'-tetrahydroxybenzophenone, 2,2'-dihydroxy-4,4'-dimethoxybenzophenone, 2,2'-dihydroxy-4-methoxybenzophenone, 2,4-dihydroxybenzophenone, 2-hydroxy-4-acetoxyethoxybenzophenone, 2-hydroxy-4-methoxybenzophenone, 2,2'-dihydroxy-4-methoxybenzophenone, 2,2'-dihydroxy-4,4'-dimethoxybenzophenone, 2-hydroxy-4-n-octoxybenzophenone, 2,2'-dihydroxy-4,4'-dimethoxy-5,5'-disulfobenzophenone disodium salt, and the like.

Examples of the cyclic imino ester ultraviolet absorber include 2,2'-(1,4-phenylene)bis(4H-3,1-benzoxazine-4-one), 2-methyl-3,1-benzoxazine-4-one, 2-butyl-3,1-benzoxazine-4-one, 2-phenyl-3,1-benzoxazine-4-one, 2-(1- or 2-naphthyl)-3,1-benzoxazine-4-one, 2-(4-biphenyl)-3,1-benzoxazine-4-one, 2-p-nitrophenyl-3,1-benzoxazine-4-one, 2-m-nitrophenyl-3,1-benzoxazine-4-one, 2-p-benzoylphenyl-3,1-benzoxazine-4-one, 2-p-methoxyphenyl-3,1-benzoxazine-4-one, 2-o-methoxyphenyl-3,1-benzoxazine-4-one, 2-cyclohexyl-3,1-benzoxazine-4-one, 2-p-(or m-)phthalimidephenyl-3,1-benzoxazine-4-one, 2,2'-(1,4-phenylene)bis(4H-3,1-benzoxazinone-4-one), 2,2'-bis(3,1-benzoxazine-4-one), 2,2'-ethylenebis(3,1-benzoxazine-4-one), 2,2'-tetramethylenebis(3,1-benzoxazine-4-one), 2,2'-decamethylenebis(3,1-benzoxazine-4-one), 2,2'-p-phenylenebis(3,1-benzoxazine-4-one), 2,2'-m-phenylenebis(3,1-benzoxazine-4-one), 2,2'-(4,4'-diphenylene)bis(3,1-benzoxazine-4-one), 2,2'-(2,6- or 1,5-naphthalene)bis(3,1-benzoxazine-4-one), 2,2'-(2-methyl-p-phenylene)bis(3,1-benzoxazine-4-one), 2,2'-(2-nitro-p-phenylene)bis(3,1-benzoxazine-4-one), 2,2'-(2-chloro-p-phenylene)bis(3,1-benzoxazine-4-one), 2,2'-(1,4-cyclohexylene)bis(3,1-benzoxazine-4-one), 1,3,5-tri(3,1-benzoxazine-4-one-2-yl)benzene, and the like.

As the above cyclic imino ester ultraviolet absorber, it is also possible to use 1,3,5-tri(3,1-benzoxazine-4-one-2-yl)naphthalene and 2,4,6-tri(3,1-benzoxazine-4-one-2-yl)naphthalene, 2,8-dimethyl-4H,6H-benzo(1,2-d;5,4-d')bis-(1,3)-oxazine-4,6-dione, 2,7-dimethyl-4H,9H-benzo(1,2-d;5,4-d')bis-(1,3)-oxazine-4,9-dione, 2,8-diphenyl-4H,8H-benzo(1,2-d;5,4-d')bis-(1,3)-oxazine-4,6-dione, 2,7-diphenyl-4H,9H-benzo(1,2-d;5,4-d')bis-(1,3)-oxazine-4,6-dione, 6,6'-bis(2-methyl-4H,3,1-benzoxazine-4-one), 6,6'-bis(2-ethyl-4H,3,1-benzoxazine-4-one), 6,6'-bis(2-phenyl-4H,3,1-benzoxazine-4-one), 6,6'-methylenebis(2-methyl-4H,3,1-benzoxazine-4-one), 6,6'-methylenebis(2-phenyl-4H,3,1-benzoxazine-4-one), 6,6'-ethylenebis(2-methyl-4H,3,1-benzoxazine-4-one), 6,6'-ethylenebis(2-phenyl-4H,3,1-benzoxazine-4-one), 6,6'-butylenebis(2-methyl-4H,3,1-benzoxazine-4-one), 6,6'-butylenebis(2-phenyl-4H,3,1-benzoxazine-4-one), 6,6'-oxybis(2-methyl-4H,3,1-benzoxazine-4-one), 6,6'-oxybis(2-phenyl-4H,3,1-benzoxazine-4-one), 6,6'-sulfonylbis(2-methyl-4H,3,1-benzoxazine-4-one), 6,6'-sulfonylbis(2-phenyl-4H,3,1-benzoxazine-4-one), 6,6'-carbonylbis(2-methyl-4H,3,1-benzoxazine-4-one), 6,6'-carbonylbis(2-phenyl-4H,3,1-benzoxazine-4-one), 7,7'-methylenebis(2-methyl-4H,3,1-benzoxazine-4-one), 7,7'-methylenebis(2-phenyl-4H,3,1-benzoxazine-4-one), 7,7'-bis(2-methyl-4H,3,1-benzoxazine-4-one), 7,7'-ethylenebis(2-methyl-4H,3,1-benzoxazine-4-one), 7,7'-oxybis(2-methyl-4H,3,1-benzoxazine-4-one), 7,7'-sulfonylbis(2-methyl-4H,3,1-benzoxazine-4-one), 7,7'-carbonylbis(2-methyl-4H,3,1-benzoxazine-4-one), 6,7'-bis(2-methyl-4H,3,1-benzoxazine-4-one), 6,7'-bis(2-phenyl-4H,3,1-benzoxazine-4-one), 6,7'-methylenebis(2-methyl-4H,3,1-benzoxazine-4-one), 6,7'-methylenebis(2-phenyl-4H,3,1-benzoxazine-4-one), or the like.

Among them, the ultraviolet absorber is preferably the benzotriazole ultraviolet absorber.

When the solid content forming the adhesive agent layer 15 is defined as 100 mass%, the content of the ultraviolet absorber is preferably 0.1 to 15 mass%, more preferably 0.3 to 10 mass%, and further preferably 0.5 to 7 mass%.

As components other than the adhesive agent and the ultraviolet absorber, the adhesive agent layer 15 may include a processing aid, a pigment, a flame retardant, a filler, a softener, a hydrolysis inhibitor, a light stabilizer, a curing agent, a crosslinking agent (e.g., polyisocyanate compound), a solvent, and the like. When a crosslinking agent (e.g., polyisocyanate compound) is used, a main agent and a supplementary agent including the crosslinking agent (e.g., polyisocyanate compound) are separately prepared, and may be mixed together at the time of use.

The adhesive agent layer is preferably an adhesive agent layer which is curable at room temperature or by heat.

For example, the application amount of the adhesive agent to the substrate can be selected from a range of 0.5 to 80 g/m², in particular, 1 to 10 g/m². For this application, for example, a gravure coater, a micro gravure coater, a reverse coater, a bar coater, a roll coater, a die coater, a doctor blade, a knife coat, or the like can be used.

Preferably, the laminated body in which the adhesive agent layer has been formed is subjected to aging after being produced. For example, the aging conditions are room temperature to 100°C; and 1 to 240 hours, and during this time, curing reaction proceeds.

The thickness of the adhesive agent layer 15 is, for example, 1 to 200 µm, preferably 3 to 150 µm, more preferably 5 to 100 µm, and further preferably 10 to 50 µm.

Preferably, the protective layer 11 is a gas barrier layer. As the protective layer 11, one obtained by combining a resin film and a gas barrier layer is preferably used, or a resin layer that exhibits gas barrier properties is preferably used. There are gas barrier layers made of resin, but a gas barrier inorganic thin film is more preferably used. As the protective layer 11, a multi-layered body composed of a gas barrier inorganic thin film and a resin layer may be used. Examples of the resin forming the protective layer 11 include a polyester resin and the like.

The polyester resin may be any polycondensate of monomer components containing a polyvalent carboxylic acid and a polyol. Specifically, examples of the polyester resin include polyethylene terephthalate-based resins, polyethylene naphthalate-based resins, polyethylene terephthalate-based resins, polybutylene naphthalate-based resins, polytrimethylene terephthalate-based resins, and the like. One type of these may be used individually, or two types or more of these may be used in combination.

Among them, a polyethylene terephthalate-based resin and a polyethylene naphthalate-based resin are preferable.

The polyethylene terephthalate-based resin contains terephthalic acid and ethylene glycol as the monomer component, but, other than these, may contain another monomer such as isophthalic acid.

The content of the other monomer in the monomer component is, for example, 20 mole% or lower, preferably 10 mole% or lower, and more preferably 5 mole% or lower.

The protective layer 11 may contain a third component other than the polyester resin. The content of the third component is not limited as long as the content is at a level that does not affect the effects of the present invention, and is, for example, 10 mass% or lower, preferably 5 mass% or lower, and more preferably 1 mass% or lower, with respect to the solid content forming the protective layer 11.

The third component may be contained in order to impart a desired function to the polyester film forming the protective layer 11, and examples of the third component include inorganic particles and organic particles. Examples of the inorganic particles include silica particles, metal oxide particles such as zirconium oxide, titanium oxide, and zinc oxide, carbonate particles such as calcium carbonate, and the like. Examples of the organic particles include crosslinking acrylic resin particles, and the like. The inorganic particles and the organic particles can be used individually or in combination of two types or more.

The polyester film may have a single layer structure, or may have a multi-layer configuration in which a plurality of polyester layers are laminated.

Examples of the multi-layer configuration include: a two-layer configuration composed of a first polyester layer and a second polyester layer; a three-layer configuration composed of a first polyester layer (surface layer), a second polyester layer (intermediate layer), and a third polyester layer (surface layer); a three-layer configuration composed of a first polyester layer (surface layer), a second polyester layer (intermediate layer), and another first polyester layer (surface layer); and the like.

From the viewpoint of absorption of ultraviolet light and melting due to ultraviolet light, the ultraviolet transmittance (wavelength: 355 nm) of the protective layer 11 is preferably 70% or lower, more preferably 65% or lower, further preferably 60% or lower, still more preferably 30% or lower, further still more preferably 25% or lower, particularly preferably 20% or lower, and most preferably 15% or lower, and preferably 1% or higher or 2% or higher, or may be 5% or higher or 10% or higher.

The ultraviolet transmittance of the protective layer 11 can be measured as described above.

The thickness of the protective layer 11 is, for example, 0.05 µm or more and 200 µm or less, preferably 5 µm or more and 100 µm or less, and more preferably 20 µm or more and 50 µm or less.

The difference between the ultraviolet transmittance of the adhesive agent layer and the ultraviolet transmittance of the protective layer is preferably 13% or lower, more preferably 10% or lower, further preferably 8% or lower, and still more preferably 7% or lower.

It is preferable that the lamination of the protective layer 11 and the adhesive agent layer 15 is performed as below.

The adhesive agent layer 15 is obtained by applying an adhesive agent composition solution onto the protective layer 11 to form an application film, and then by drying the application film under a predetermined condition. The application method is not particularly limited, and examples thereof include roll coating, screen coating, gravure coating, and the like. As the drying condition, for example, drying is performed in a range of a drying temperature of 80 to 150°C and a drying time of 0.5 to 5 minutes. The adhesive agent composition may be applied onto a separator to form an application film, then, the application film may be dried under the above drying condition to form the adhesive agent layer 15, and then, the adhesive agent layer 15 may be attached together with the separator onto the protective layer 11.

Examples of the constituent material of the substrate 14 include: inorganic materials such as quartz, glass, sapphire, and titania; organic materials such as polyethylene (e.g., polyethylene terephthalate, polyethylene naphthalate), polyethersulfone, polyimide, polyamide (e.g., nylon), polystyrene, polyvinyl alcohol, ethylene-vinyl alcohol copolymer, fluorine resin, vinyl chloride, polyolefin (e.g., polyethylene, polypropylene), cellulose, polyvinylidene chloride, aramid, polyphenylene sulfide, polyurethane, polycarbonate, polyarylate, polynorbornene, and epoxy resin; paper materials; composite materials obtained by coating a resin on a metal such as stainless steel, titanium, or aluminum; and the like.

Among them, the constituent material of the substrate 14 is preferably an inorganic material and more preferably glass.

Examples of the shape of the substrate 14 include a plate shape, a film shape, a sheet shape, and the like. The thickness of the substrate 14 is preferably 5 µm or more, more preferably 20 µm or more, further preferably 50 µm or more, and preferably 20 mm or less, more preferably 1 mm or less, and further preferably 0.7 mm or less.

The device 10 of the present invention may have the transparent electrically-conductive layer 12, the electrically-conductive layer 13, an electron transport layer 16, an active layer 17, and a hole transport layer 18, in addition to the substrate 14, the protective layer 11, and the adhesive agent layer 15, and preferably has a region composed of the substrate 14, the protective layer 11, and the adhesive agent layer 15, and a region composed of the substrate 14, the transparent electrically-conductive layer 12, the electron transport layer 16, the active layer 17, the hole transport layer 18, the electrically-conductive layer 13, the adhesive agent layer 15, and the protective layer 11.

The transparent electrically-conductive layer 12 and the electrically-conductive layer 13 are each formed from an electrically-conductive material to serve as a cathode or an anode.

Preferably, the cathode is formed from an electrically-conductive material that has a work function smaller than that of the anode. The cathode has a function of extracting electrons generated in the active layer. Examples of the constituent material of the cathode include: electrically-conductive metal oxides such as nickel oxide, tin oxide, indium oxide, indium tin oxide (ITO), indium-zirconium oxide (IZO), titanium oxide, indium oxide, and zinc oxide; metals such as gold, platinum, silver, chromium, and cobalt and alloys thereof; and the like. When the cathode is a transparent electrode, it is preferable to use a translucent electrically-conductive metal oxide such as ITO, zinc oxide, or tin oxide, and particularly preferable to use ITO.

Preferably, the anode is formed from an electrically-conductive material that has a work function larger than that of the cathode. The anode has a function of extracting holes generated in the active layer. Examples of the constituent material of the anode include: metals such as platinum, gold, silver, copper, iron, tin, zinc, aluminum, indium, chromium, lithium, sodium, potassium, cesium, calcium, and magnesium, and alloys thereof; inorganic salts such as lithium fluoride and cesium fluoride; and metal oxides such as nickel oxide, aluminum oxide, lithium oxide, and cesium oxide. When an n-type semiconductor compound that is electrically-conductive such as zinc oxide is used as the constituent material of the hole transport layer, a material having a small work function such as ITO may be used as a material of the anode.

The thicknesses of the transparent electrically-conductive layer 12 and the electrically-conductive layer 13 are each preferably 10 nm or more, more preferably 15 nm or more, and further preferably 20 nm or more, and preferably 0.1 µm or less, more preferably 0.05 µm or less, and further preferably 40 nm or less.

The electron transport layer 16 is a layer for performing extraction of electrons from the active layer 17 to the cathode. The constituent material of the electron transport layer 16 is preferably an electron-transporting material for enhancing electron extracting efficiency, and may be an organic compound or an inorganic compound. However, an inorganic compound is preferable.

The inorganic compound for forming the electron transport layer 16 is preferably a metal compound, and examples thereof include: salts of alkali metals such as lithium, sodium, potassium, and cesium; metal oxides; and the like. Among them, as the salts of alkali metals, fluoride salts such as lithium fluoride, sodium fluoride, potassium fluoride, and cesium fluoride are preferable, and as the metal oxides, a metal oxide that has n-type semiconductor characteristics such as titanium oxide (TiOx) or zinc oxide (ZnO) is preferable. Examples of the organic compound for forming the electron transport layer 16 include electrically-conductive organic compounds, and examples thereof include polyethylenimine ethoxylate and the like.

The thickness of the electron transport layer 16 is preferably 0.5 nm or more, more preferably 5.0 nm or more, and further preferably 10.0 nm or more, and preferably 200 nm or less, more preferably 100 nm or less, and further preferably 60 nm or less.

The active layer 17 is a layer in which photoelectric conversion is performed, and preferably contains a p-type semiconductor compound and an n-type semiconductor compound. When a photoelectric conversion element receives light, the light is absorbed by the active layer 17, electricity is generated at the interface between the p-type semiconductor compound and the n-type semiconductor compound, and the generated electricity is extracted from the cathode and the anode. The cathode and the anode correspond to the transparent electrically-conductive layer and the electrically-conductive layer.

As the p-type semiconductor compound and the n-type semiconductor compound, known compounds can be used. Examples of the p-type semiconductor compound include: conjugated copolymer semiconductor compounds such as polythiophene, polyfluorene, polyphenylenevinylene, polythienylenevinylene, polyacetylene, and polyaniline; copolymer semiconductor compounds such as oligothiophene in which an alkyl group or another substituent is substituted; and the like. In addition, a copolymer semiconductor compound obtained by copolymerizing two types or more of monomer units may be used.

Examples of the n-type semiconductor compound include fullerenes and derivatives thereof (e.g., PCBM), octaazaporphyrin, a perfluoro compound (e.g., perfluoropentacene or perfluorophthalocyanine) obtained by substituting a hydrogen atom of the p-type semiconductor compound with a fluorine atom, and the like. In addition, a polymer compound or the like that contains, as a skeleton, an aromatic carboxylic anhydride or an imidized product thereof such as naphthalenetetracarboxylic anhydride, naphthalenetetracarboxylic diimide, perylenetetracarboxylic anhydride, or perylenetetracarboxylic diimide can also be used.

Examples of the layer structure of the active layer 17 include a thin film lamination structure in which the p-type semiconductor compound and the n-type semiconductor compound are laminated, and a bulk heterojunction structure that has a layer in which the p-type semiconductor compound and the n-type semiconductor compound are mixed. The bulk heterojunction structure has a layer (i layer) in which the p-type semiconductor compound and the n-type semiconductor compound are mixed. The i layer has a structure in which the p-type semiconductor compound and the n-type semiconductor compound are phase-separated, carrier separation occurs at the phase interface, and the generated carriers (holes and electrons) are transported to the electrodes. From the viewpoint of enhancing the photoelectric conversion efficiency by obtaining a good phase-separated structure, the mass ratio (p-type semiconductor compound/n-type semiconductor compound) between the p-type semiconductor compound and the n-type semiconductor compound in the i layer is preferably 0.5 or more and 2 or less, and more preferably 0.8 or more and 1.25 or less.

The active layer 17 may contain an additive in addition to the p-type semiconductor compound and the n-type semiconductor compound. The phase-separated structure between the p-type semiconductor compound and the n-type semiconductor compound in the active layer of the bulk heterojunction type may influence light absorption, generation/diffusion of excitons, dissociation of excitons (carrier separation), carrier transportation, and the like. Therefore, it is expected to optimize the phase-separated structure to realize good photoelectric conversion efficiency. When the active layer 17 includes an additive having a high affinity to the p-type semiconductor compound or the n-type semiconductor compound, an active layer having a preferable phase-separated structure is obtained, and the photoelectric conversion efficiency can be enhanced.

Examples of the additive include aliphatic hydrocarbon compounds each having 8 to 20 carbon atoms and aromatic compounds each having 8 to 20 carbon atoms. These aliphatic hydrocarbon compounds and aromatic compounds may have a substituent. Examples of the substituent that the aliphatic hydrocarbon compound may have include a halogen atom, a hydroxy group, a mercapto group, a cyano group, an amino group, a carbamoyl group, a carbonyloxy group, a carboxyl group, a carbonyl group, an aromatic group, and the like. Examples of the substituent that the aromatic compound may have include a halogen atom, a hydroxy group, a cyano group, an amino group, an amide group, a carbonyloxy group, a carboxy group, a carbonyl group, an oxycarbonyl group, a silyl group, an alkenyl group, an alkynyl group, an alkoxy group, an aryloxy group, an alkylthio group, an arylthio group, an aromatic group, and the like. Preferable specific examples of the additive include benzene that may have a substituent, naphthalene that may have a substituent, octane that may have a substituent, and the like. As the substituent, a halogen atom is particularly preferable.

In the present invention, from the viewpoint of obtaining a photoelectric conversion element for an organic thin-film solar cell, etc. that exhibits high conversion efficiency, the active layer 17 is preferably an organic semiconductor, and more preferably contains a p-type semiconductor compound that is a polymer compound described later and/or an n-type semiconductor compound that is a polymer compound described later or the above-described n-type semiconductor compound.

Examples of the p-type semiconductor compound that is a polymer compound include PDPPBDT, PDPPDTT, PFs, KP115, PCDTBT, DPPT-TT, PDPP2FT, F82T, F8TBT, F8BT, P3HT-Br10, PPP-P3HT, P3HT, PhxSDT-DTZ, PBDTDPP-1, P3DDT, PPDTBT, PPDT2FBT, PBDTDPP-2, PCPDTBT-1, PCPDTBT-2, PBDBT2F (PM6), and the like.

Examples of the n-type semiconductor compound that is a polymer compound include MEH-CN-PPV, F8TBT, PZ1, DCNBT-IDT, P-BNBP-fBT, PF2-DTSi, PDI-V, PYT_{M}, PJ1-H, N2200, Y6, and the like.

In the present invention, the active layer 17 may contain a polymer compound having a benzobisthiazole structural unit, and specifically, preferably contains a polymer compound (hereinafter, referred to as "polymer compound P") having a benzobisthiazole structural unit represented by the following formula (1).

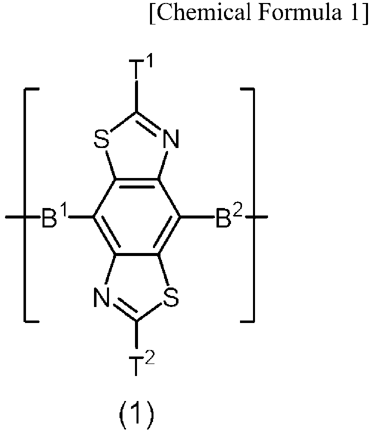

In formula (1), T¹ and T² each independently represent an alkoxy group, a thioalkoxy group, a thiophene ring that is optionally substituted with a hydrocarbon group or an organosilyl group, a thiazole ring that is optionally substituted with a hydrocarbon group or an organosilyl group, or a phenyl group that is optionally substituted with a hydrocarbon group, an alkoxy group, a thioalkoxy group, an organosilyl group, a halogen atom, or a trifluoromethyl group.

In addition, B¹ and B² each represent a thiophene ring that is optionally substituted with a hydrocarbon group, a thiazole ring that is optionally substituted with a hydrocarbon group, or an ethynylene group. An organosilyl group represents a monovalent group in which an Si atom has one or more hydrocarbon groups as a substituent, and the number of the hydrocarbon groups which the Si atom has as substituents is preferably two or more and three or less, and more preferably three.

The polymer compound P is one kind of the p-type semiconductor compound, and narrowing the band gap while deepening the HOMO level can increase the photoelectric conversion efficiency by having a benzobisthiazole structural unit represented by formula (1).

In the benzobisthiazole structural unit represented by formula (1), T¹ and T² may be the same or different from each other. However, T¹ and T² are preferably the same from the viewpoint of facilitating the production. Similarly, B¹ and B² may be the same or different from each other. However, B¹ and B² are preferably the same from the viewpoint of facilitating the production.

In the benzobisthiazole structural unit represented by formula (1), each of T¹ and T² preferably represents a group represented by one of the following formulas (t1) to (t5). Specifically, as each of T¹ and T², the alkoxy group is preferably a group represented by the following formula (t1), the thioalkoxy group is preferably a group represented by the following formula (t2), the thiophene ring that is optionally substituted with a hydrocarbon group or an organosilyl group is preferably a group represented by the following formula (t3), the thiazole ring that is optionally substituted with a hydrocarbon group or an organosilyl group is preferably a group represented by the following formula (t4), and a phenyl group that is optionally substituted with a hydrocarbon group, an alkoxy group, a thioalkoxy group, an organosilyl group, a halogen atom, or a trifluoromethyl group is preferably a group represented by the following formula (t5). In a case where T¹ and T² are each a group represented by one of the following formulas (t1) to (t5), light having a short wavelength can be absorbed, and, furthermore, planarity is high, and π-π stacking is thus efficiently formed, thereby further improving the photoelectric conversion efficiency. The groups represented by formulas (t1) to (t3) are electron-donating, while the groups represented by formulas (t4) to (t5) are electron-withdrawing.

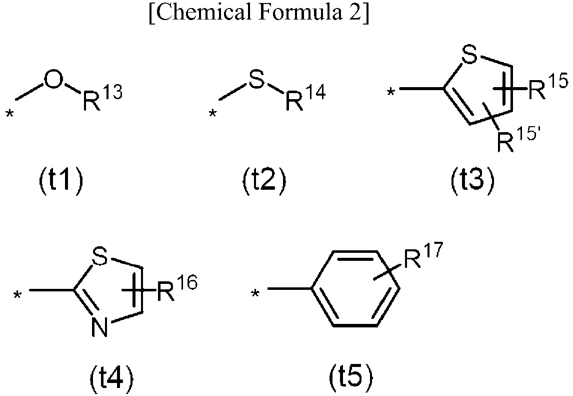

[In formulas (t1) to (t5),
R¹³ to R¹⁴ each independently represent a C6 to C30 hydrocarbon group.
R¹⁵ to R¹⁶ each independently represent a C6 to C30 hydrocarbon group or a group represented by *-Si(R¹⁸)₃. R^{15'} represents a hydrogen atom, a C6 to C30 hydrocarbon group, or a group represented by *-Si(R¹⁸)₃. R¹⁷ each independently represent a halogen atom, a C6 to C30 hydrocarbon group, *-O-R¹⁹, *-S-R²⁰, *-Si(R¹⁸)₃, or *-CF₃.
R¹⁸ each independently represent a C1 to C20 aliphatic hydrocarbon group or a C6 to C10 aromatic hydrocarbon group, and a plurality of R¹⁸s may be the same or different from each other. R¹⁹ to R²⁰ each represent a C6 to C30 hydrocarbon group.
* represents a bond moiety for bonding to a thiazole ring of benzobisthiazole.]

In formulas (t1) to (t5), the C6 to C30 hydrocarbon group of R¹³ to R¹⁷, R¹⁹ to R²⁰, and R^{15'} is preferably a branched hydrocarbon group, and more preferably a branched-chain saturated hydrocarbon group. The hydrocarbon group of R¹³ to R¹⁷, R¹⁹ to R²⁰, and R^{15'} is branched, and thus, solubility with respect to an organic solvent can be enhanced. The number of carbon atoms in the hydrocarbon group of R¹³ to R¹⁷, R¹⁹ to R²⁰, and R^{15'} is preferably 8 to 25, more preferably 8 to 20, and further preferably 8 to 16.

In the group represented by *-Si(R¹⁸)₃ of R¹⁵ to R¹⁷ and R^{15'} in formulas (t1) to (t5), the number of carbon atoms of the aliphatic hydrocarbon group of R¹⁸ is preferably 1 to 18 and more preferably 1 to 8. The number of carbon atoms of the aromatic hydrocarbon group of R¹⁸ is preferably 6 to 8, more preferably 6 to 7, and particularly preferably 6. Examples of the aromatic hydrocarbon group of R¹⁸ include a phenyl group. Among them, R¹⁸ is preferably an aliphatic hydrocarbon group, more preferably a branched aliphatic hydrocarbon group, and particularly preferably an isopropyl group. The plurality of R¹⁸s may be the same or different from each other. However, the plurality of R¹⁸s are preferably the same. In a case where R¹⁵ to R¹⁷ and R^{15'} are each a group represented by *-Si(R¹⁸)₃, the polymer compound P of the present invention has enhanced solubility with respect to an organic solvent. The group represented by *-Si(R¹⁸)₃ is preferably an alkyl silyl group, more preferably a trimethylsilyl group and a triisopropylsilyl group.

In a case where R¹⁷ is a halogen atom in formula (t5), any of fluorine, chlorine, bromine, and iodine may be used. R¹⁷ is preferably a halogen atom or *-CF₃.

R^{15'} represents a hydrogen atom, a C6 to C30 hydrocarbon group indicated as examples of R¹⁵, or a group represented by *-Si(R¹⁸)₃. R^{15'} is preferably a hydrogen atom.

As the electron-donating group of T¹ and T², the groups represented by formulas (t1), (t3), and (t5) are more preferable, the group represented by formula (t3) is even more preferable from the viewpoint that planarity is excellent over the entirety of the structural unit represented by formula (1).

In the benzo(bis)thiazole structural unit represented by formula (1), each of B¹ and B² preferably represents a group represented by any one of the following formulas (b1) to (b3). In a case where each of B¹ and B² represents a group represented by any one of the following formulas (b1) to (b3), the obtained polymer compound P has good planarity, and the photoelectric conversion efficiency can be further improved.

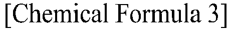

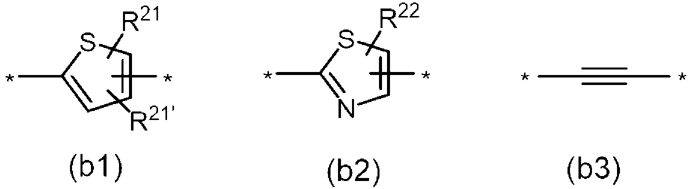

[In formulas (b1) to (b3), R²¹, R²², and R^{21'} each represent a hydrogen atom or a C6 to C30 hydrocarbon group.

* represents a bond moiety, and, in particular, * on the left side represents a bond moiety for bonding to a benzene ring of the benzo(bis)thiazole compound.]

As the C6 to C30 hydrocarbon group of R²¹, R²², and R^{21'}, groups indicated as examples of the C6 to C30 hydrocarbon groups of R¹³ to R¹⁷, R¹⁹ to R²⁰, and R^{15'} can be preferably used.

R²¹, R²², R^{21'} representing the C6 to C30 hydrocarbon group is preferable since the photoelectric conversion efficiency can be further improved. R²¹, R²², R^{21'} representing a hydrogen atom is preferable since a donor-acceptor semiconductor polymer is easily formed.

B¹ and B² more preferably represent groups represented by formulas (b1) and (b2). In a case where B¹ and B² represent the groups represented by formulas (b1) and (b2), interaction between S atoms and N atoms is caused in the benzo(bis)thiazole structural unit (1) to further enhance planarity. As a result, the flatness of the resulting polymer compound P can be enhanced.

The polymer compound P is preferably a donor-acceptor type semiconductor polymer, and thus the polymer compound P preferably has a benzobisothiazole structural unit represented by formula (1) and a specific structural unit that gives a donor or acceptor unit. The donor unit means an electron-donating structural unit and the acceptor unit means an electron-accepting structural unit. The donor-acceptor semiconductor polymer preferably has the donor and acceptor units arranged alternately, and thus the donor-acceptor semiconductor polymer is preferably a polymer in which the benzobisothiazole structural unit represented by formula (1) and the specific structural units are arranged alternately. The polymer compound P can be suitably used as a p-type semiconductor compound by having such a structure.

As specific structural units, conventionally known structural units that provide donor or acceptor units can be used. Specifically, structural units of the following formulas can be listed as specific structural units, among which structural units represented by formulas (c1), (c3) to (c5), (c7), (c9), (c12), (c21), (c27), (c37), and (c42) are preferred, and formulas (c1), (c5), (c9), (c21), (c37), (c42) are more preferred.

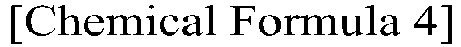

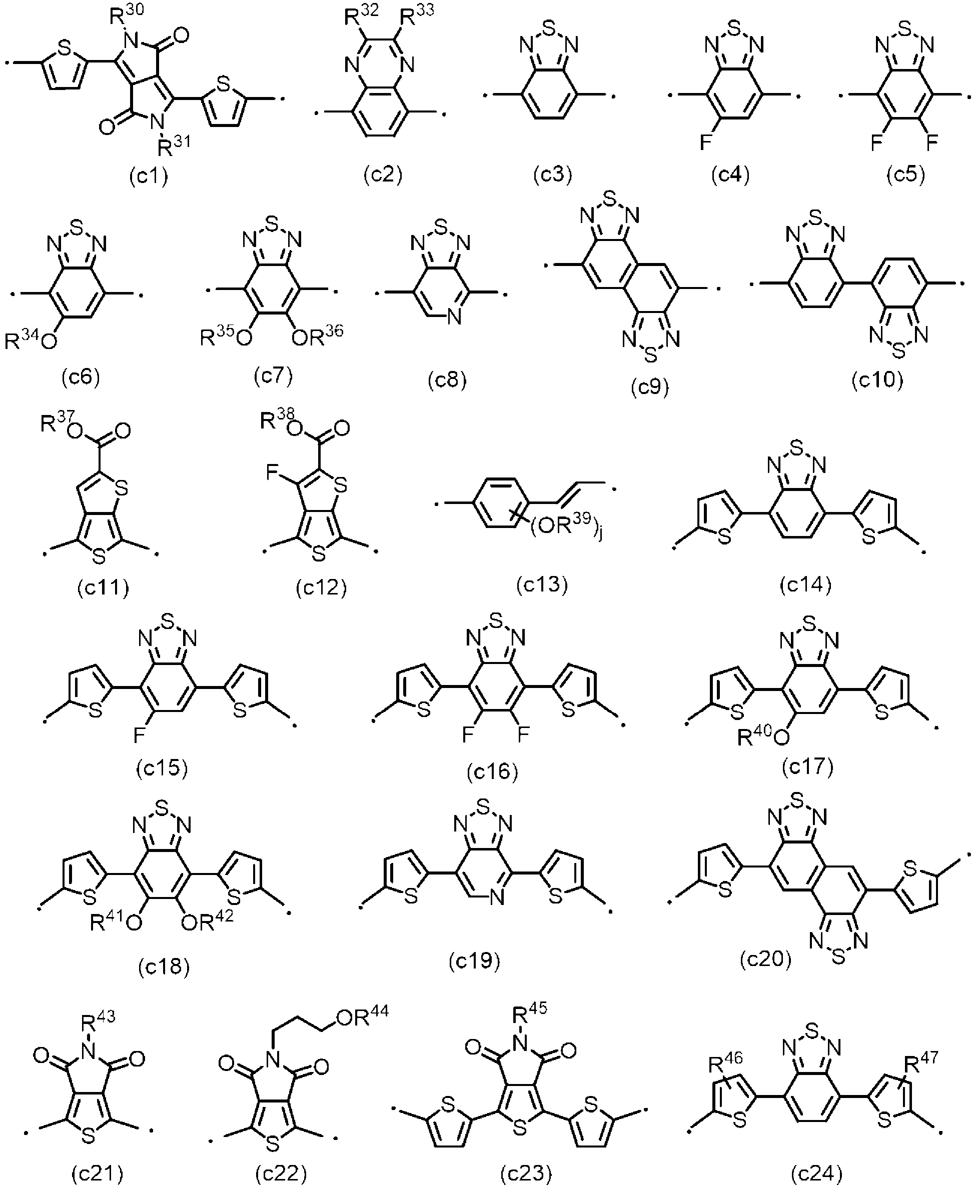

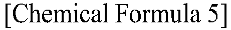

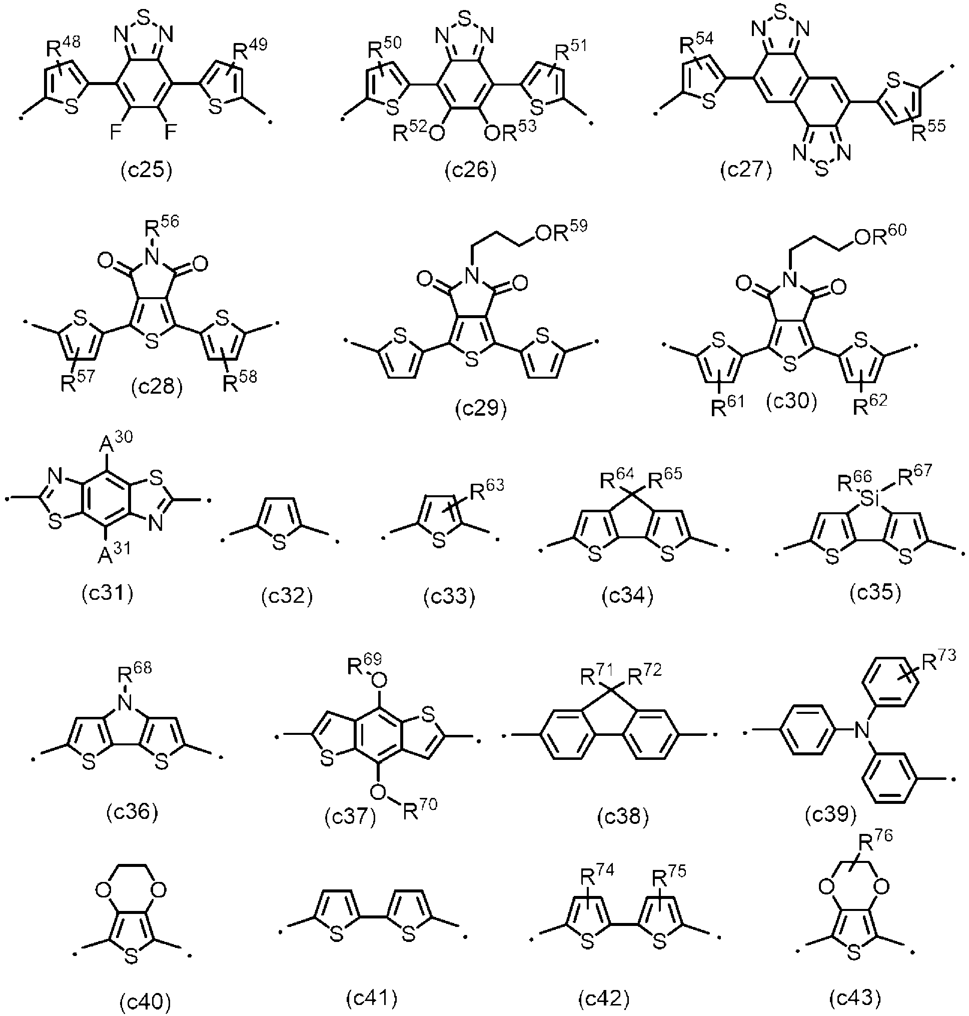

In the above formulae (c1) to (c43), R³⁰ to R⁷⁶ each independently represent a hydrogen atom or a hydrocarbon group having 4 to 30 carbon atoms; A³⁰ and A³¹ each independently represent a group similar to T¹ and T², and j represents an integer from 1 to 4. · " · " represent a bonding hand bonded to B¹ or B² of the structural unit represented by formula (1).

The groups represented by formulas (c1) through (c30) above are groups that act as acceptor units, and the groups represented by formulas (c32) through (c43) are groups that act as donor units. The group represented by formula (c31) may act as an acceptor unit or a donor unit, depending on the type of A³⁰ and A³¹.

The repeat ratio of the benzobisothiazole structural unit represented by formula (1) in the polymer compound P is usually 1 mole% or more, preferably 5 mole% or more, more preferably 15 mole% or more, further preferably 30 mole% or more, usually 99 mole% or less, preferably 95 mole% or less, more preferably 85 mole% or less, further preferably 70 mole% or less.

The repeat ratio of the specific structural unit in the polymer compound P is usually 1 mole% or more, preferably 5 mole% or more, more preferably 15 mole% or more, further preferably 30 mole% or more, and is usually 99 mole% or less, preferably 95 mole% or less, more preferably 85 mole% or less, further preferably 70 mole% or less.

The alignment of the benzobisothiazole structural unit represented by formula (1) and the specific structural unit in the repeating unit of the polymer compound P may be in any one of an alternating, block, and random states. That is, the polymer compound P may be any of an alternating copolymer, a block copolymer, and a random copolymer. The benzobisothiazole structural unit represented by formula (1) and the specific structural unit preferably alternate.

The weight average molecular weight and number average molecular weight of polymer compound P should be between 2,000 and 500,000, and between 3,000 and 200,000. The weight average molecular weight and number average molecular weight of the polymer compound P can be calculated based on a calibration curve prepared using gel permeation chromatography and polystyrene as a standard sample.

The thickness of the active layer 17 is preferably 70 nm or more, more preferably 90 nm or more, further preferably 100 nm or more, and preferably 1000 nm or less, more preferably 500 nm or less, and further preferably 300 nm or less.

The hole transport layer 18 is a layer that extracts holes from the active layer 17 to the anode. The constituent materials of the hole transport layer 18 are not limited as long as they are hole-transporting materials capable of improving the efficiency of hole extraction, and include conductive organic compounds and metal compounds.

Conductive organic compounds constituting the hole transport layer 18 include, for example, conductive polymers such as polythiophene, polypyrrole, polyacetylene, triphenylenediamine, and polyaniline doped with sulfonic acid and/or iodine, polythiophene derivatives with sulfonyl groups as substituent groups, arylamines, and the like. Metal compounds comprising the hole transport layer include metal oxides having p-type semiconductor properties such as molybdenum trioxide, vanadium pentoxide, and nickel oxide, as well as metals such as gold, indium, silver, and palladium. The hole transport layer may also be formed from p-type semiconductor compounds. Among these, conductive polymers doped with sulfonic acid are preferred as the constituent material of the hole transport layer 18. Poly(3,4-ethylenedioxythiophene) poly(styrenesulfonic acid), which is a polythiophene derivative doped with poly(styrenesulfonic acid) (PEDOT:PSS) is more preferred, and metal oxides such as molybdenum oxide and vanadium oxide are also preferred.

The thickness of the hole transport layer 18 is preferably 0.2 nm or more, more preferably 5.0 nm or more, further preferably 30.0 nm or more, and preferably 400 nm or less, more preferably 200 nm or less, further preferably 100 nm or less, further more preferably 70 nm or less.

### 2. Method for manufacturing the device

A method for manufacturing the device of the present invention includes: steps of forming a structure body including a substrate, a first laminated body on a first region of the substrate, and a second laminated body on a second region different from the first region of the substrate (hereinafter, also referred to as a structure body forming step); adhering a protective layer provided with an adhesive agent layer having ultraviolet transmittance (wavelength: 355 nm) of 30% or lower, via the adhesive agent layer, onto the structure body of the first laminated body and the second laminated body (hereinafter, also referred to as a step of adhering the protective layer and the structure body); and irradiating ultraviolet light into a third region between the first laminated body and the second laminated body of the structure body, to melt a part of the third region of the substrate, the adhesive agent layer, and the protective layer (hereinafter, also referred to as a melting step).

The method for manufacturing the device of the present invention allows the structure body including the substrate, the protective layer, and the adhesive agent layer between the substrate and the protective layer to be cut through ultraviolet irradiation, and thus, the device can be efficiently divided and can be caused to have good cut portions and good power generation characteristics after storage.

### Structure body forming step

The structure body forming step is a step in which a laminated body (e.g., the first laminated body and the second laminated body) is provided in a predetermined region (e.g., the first region and the second region) of the substrate, to form a structure body including the substrate and the laminated body.

The substrate may have one, two, or more regions, and the respective regions are preferably regions different from or independent of each other, and preferably, the laminated bodies provided in the respective regions are able to operate independently of each other.

As an example, when the substrate has a first region and a second region, and a first laminated body and a second laminated body are provided to the first region and the second region, respectively, it is preferable that the first laminated body includes a first electron transport layer, a first hole transport layer, and a first active layer between the first electron transport layer and the first hole transport layer, and the second laminated body includes a second electron transport layer, a second hole transport layer, and a second active layer between the second electron transport layer and the second hole transport layer.

The first laminated body may further include a first transparent electrically-conductive layer and a first electrically-conductive layer, and the second laminated body may further include a second transparent electrically-conductive layer and a second electrically-conductive layer.

The first transparent electrically-conductive layer is preferably provided between the substrate and the first electron transport layer, the first electrically-conductive layer is preferably provided to the first hole transport layer, the second transparent electrically-conductive layer is preferably provided between the substrate and the second electron transport layer, and the second electrically-conductive layer is preferably provided to the second hole transport layer.

That is, it is preferable that, in the first region of the substrate, the first transparent electrically-conductive layer, the first electron transport layer, the first active layer, the first hole transport layer, and the first electrically-conductive layer are formed in this order, and it is preferable that, in the second region of the substrate, the second transparent electrically-conductive layer, the second electron transport layer, the second active layer, the second hole transport layer, and the second electrically-conductive layer are formed in this order.

The materials of the substrate, the transparent electrically-conductive layer, the electron transport layer, the active layer, the hole transport layer, and the electrically-conductive layer are the same as those described above.

In the structure body, between the portion where the first laminated body is provided and the portion where the second laminated body is provided, the third region is preferably present as an ultraviolet irradiation region. The third region is preferably a portion where the transparent electrically-conductive layer, the hole transport layer, the active layer, the electron transport layer, and the electrically-conductive layer are not formed on the substrate, and is preferably a portion where the substrate is exposed before the protective layer is adhered.

The third region may be a region that equally divides the regions (e.g., the first region and the second region).

In the method for manufacturing the device of the present invention, the substrate may have a fourth region, a fifth region, and the like, not limited to the first region and the second region, and laminated bodies that can independently operate may be provided to the respective regions, to form the structure body.

When the substrate has three or more regions, the above third region may be positioned between the respective regions. For example, when the substrate has four regions (the first region, the second region, the fourth region, and the fifth region), the above third region may be positioned so as to equally divide these regions.

### Step of adhering the protective layer and the structure body

The step of adhering the protective layer and the structure body is a step of adhering the protective layer provided with an adhesive agent layer, onto the structure body over the first laminated body and the second laminated body via the adhesive agent layer.

The step is not particularly limited as long as the step prevents air from entering between the protective layer and the laminated body. Only an existing method such as atmospheric lamination, vacuum lamination, press, or vacuum press may be used, or after these, heating may be added by using an oven, a pressurized oven, an autoclave, or the like.

The ultraviolet transmittance (wavelength: 355 nm) of the adhesive agent layer is 30% or lower, preferably 29% or lower, more preferably 28% or lower, and further preferably 27% or lower, and preferably 1% or higher or 2% or higher, and more preferably 5% or higher, or may be 10% or higher. When the transmittance is in the above range, cutting characteristics due to ultraviolet light of the substrate, the protective layer, and the adhesive agent layer become good, the deterioration region caused by ultraviolet irradiation is small, and storage characteristics can also be made good. When the transmittance is higher than 30%, cutting characteristics due to ultraviolet light of the substrate, the protective layer, and the adhesive agent layer are not sufficient, the deterioration region caused by ultraviolet irradiation becomes large, and the storage characteristics may fail to be sufficient, either.

The materials of the protective layer and the adhesive agent layer may be the same as above. The protective layer and the adhesive agent layer may have formed therein, in advance, openings for extracting a current from the transparent electrically-conductive layer and the electrically-conductive layer.

In the step, preferably, the substrate is in contact with the adhesive agent layer in the third region. That is, the portion present in the third region of the structure is preferably composed of the substrate, the adhesive agent layer, and the protective layer.

In the following, with reference to FIGS. 2(a), 2(b), the relationship between the regions of the substrate will be described.

FIG. 2(a) represents a top view of the device after the protective layer is adhered, via the adhesive agent layer, over the first laminated body on the first region and the second laminated body on the second region in the method for manufacturing the device according to an embodiment of the present invention. FIG. 2(b) represents a top view of the device after the protective layer is adhered, via the adhesive agent layer, over the respective laminated bodies on the first region, the second region, the fourth region, and the fifth region in the method for manufacturing the device according to another embodiment of the present invention.

In FIG. 2(a), the device 100 is formed by adhering, via the adhesive agent layer, the protective layer 11 to the structure body including the substrate and the laminated body. The substrate has a first region A and a second region B. The protective layer 11 is adhered, via the adhesive agent layer, to the structure body including the substrate, the first laminated body on the first region A, and the second laminated body on the second region B. The structure body has a region (third region 20) between the first region A and the second region B. The portion present in the third region 20 of the structure body is composed of the substrate, the adhesive agent layer, and the protective layer, for example, and can be used as an ultraviolet irradiation region. The protective layer 11 and the adhesive agent layer in each region is provided with a plurality of openings, a certain opening serves as an exposure part for the transparent electrically-conductive layer 12, another opening serves as an exposure part for the electrically-conductive layer 13, and the provision of these openings allows a current to be extracted from the device 100.

In FIG. 2(b), the device 100 is formed by adhering, via the adhesive agent layer, the protective layer 11 to the structure body including the substrate and the laminated body. The substrate has the first region A, the second region B, a fourth region C, and a fifth region D, and the protective layer 11 is adhered, via the adhesive agent layer, to the structure body including the substrate, a laminated body on the first region A, a laminated body on the second region B, a laminated body on the fourth region C, and a laminated body on the fifth region D. The third region 20 of the structure body may be positioned in each of: between the first region A and the second region B; between the first region A and the fourth region C; between the second region B and the fifth region D; and between the fourth region C and the fifth region D. The portion present in the third region 20 of the structure body is composed of the substrate, the adhesive agent layer, and the protective layer, for example, and can be used as an ultraviolet irradiation region. The protective layer 11 and the adhesive agent layer in each region is provided with a plurality of openings, a certain opening serves as an exposure part for the transparent electrically-conductive layer 12, another opening serves as an exposure part for the electrically-conductive layer 13, and the provision of these openings allows a current to be extracted from the device 100.

### Melting step

The melting step is a step of irradiating ultraviolet light into a third region between the first laminated body and the second laminated body to melt a portion present in the third region of the substrate, the adhesive agent layer, and the protective layer.

Ultraviolet light irradiation is performed onto the third region to serve as the ultraviolet irradiation region. Accordingly, the substrate, the adhesive agent layer, and the protective layer present in the third region are melted, whereby the device is cut into a structure body including the substrate and the first laminated body in the first region and a structure body including the substrate and the second laminated body in the second region.

The device and the method for manufacturing the device of the present invention can be suitably used for an organic EL, an organic thin-film transistor, an organic thin-film solar cell, and the like.

The present application claims benefit of priority to Japanese Patent Application No. 2023-004043 filed on January 13, 2023. The entire contents of the specification of Japanese Patent Application No. 2023-004043 filed on January 13, 2023, are incorporated herein by reference.

### EXAMPLES

The present invention will be specifically explained with the following Example without limiting by the Examples and can of course be implemented with appropriate changes to the extent that it conforms to the purposes described above and below, all of which are included in the technical scope of the present invention. In the following, unless otherwise specified, "part" means "parts by mass" and "%" means "mass %".

### (Production of photoelectric conversion element)

A glass substrate (thickness: 700 µm), manufactured by GEOMATEC Co., Ltd., patterned with an indium tin oxide (ITO) transparent electrically-conductive film (cathode) to serve as an electrode was ultrasonically washed with acetone, then ultrasonically washed with ethanol, and then, dried by nitrogen blowing. After the dried glass substrate was subjected to UV-ozone treatment, an electron transport layer was formed.

The electron transport layer was formed by applying (1500 rpm, 50 seconds) a 0.5 M zinc acetate·0.5 M aminoethanol/2-methoxyethanol solution to the glass substrate by a spin coater, and then annealing the obtained product at 135°C for 10 minutes.

The glass substrate on which the electron transport layer has been formed was put in a glove box, spin-coating (1000 rpm, 45 seconds) of a mixture solution 1 of the p-type semiconductor compound and the n-type semiconductor compound was performed in an inert gas atmosphere, and the obtained product was annealed on a hot plate at 100°C for 5 minutes, to form an active layer. Commercial reagents, i.e., P3HT and PCBM, were used as the p-type semiconductor compound and the n-type semiconductor compound. After each layer was produced, the area around the element part was wiped off, whereby layers of independent four elements were produced on the single glass substrate.

Next, molybdenum oxide as a hole transport layer was deposited on the active layer by a deposition machine. The degree of vacuum of 7×10⁻⁴ Pa was confirmed before the deposition was started, and then vacuum deposition was performed using a resistance heating crucible. Then, boat deposition of silver as an electrode (anode) was performed on the hole transport layer, to produce a reverse-configuration-type device including the independent four elements. With the initial deposition rate set to 0.05 angstrom/second, the deposition rate was gradually increased, and the deposition rate was controlled to be 0.5 angstrom/second or less.

A gas barrier film provided with an adhesive agent was laminated to be adhered, as the protective layer provided with an adhesive agent layer, onto the obtained reverse-configuration-type device including the four elements (see FIG. 2(b)). At this time, for the electrode part, the film having holes therein was used.

As the substrate film, PET film E4100 having a thickness of 100 µm manufactured by TOYOBO Co., Ltd., or PEN film Q65HA having a thickness of 50 µm manufactured by TOYOBO Co., Ltd., was used. An epoxy adhesive agent or a urethane adhesive agent was applied to the PET film or the PEN film by a bar coater.

In Example 1, as the epoxy adhesive agent, a mixture of, approximately: 52 parts of ACRYDIC A-808-T (DIC Corporation, hydroxy group containing acrylic resin, Tg of 70°C, hydroxyl value of 20 to 40 mg KOH/g); 6 parts of EPICLON 860 (DIC Corporation, bisphenol A-type epoxy resin, epoxy equivalent weight of 240 g/eq); 2 parts of DURANOL T-5651 (Asahi Kasei Chemicals Corporation, polycarbonate diol, number average molecular weight of 1000, hydroxyl value of 100 to 120 mg KOH/g); 1 part of ELASTOSTAB (Elastogran AG, isocyanate); 5 parts of Tinuvin 123 (BASF Japan Ltd., light stabilizer); 37 parts of ethyl acetate; 4 parts of SUMIDUR N3300 (Sumika Bayer Urethane Co., Ltd., HDI isocyanate-type polyisocyanate, NCO 22%); and 1 part of benzotriazole (also referred to as UV absorber A), was used.

In Example 2, as the urethane adhesive agent, to a hydroxy-group-introduced methacrylic acid ester resin having a number average molecular weight of 50000 obtained by copolymerizing 65% of methyl methacrylate and 35% of 2-hydroxyethyl methacrylate, 5% of 2-(2H-benzotriazole-2-yl)-4,6-di-t-pentylphenol (TINUVIN 328; manufactured by Ciba Specialty Chemicals Inc.) (also referred to as UV absorber B) being a benzotriazole ultraviolet absorber to serve as the ultraviolet absorber, and 5% of decanedioic acid, bis[2,2,6,6-tetramethyl-1(octyloxy)-4-piperidinyl]ester (TINUVIN 123; manufactured by Ciba Specialty Chemicals Inc.) being a hindered-amine light stabilizer to serve as the light stabilizer were blended, and the obtained product was diluted with methyl ethyl ketone for viscosity adjustment, whereby a main agent (a) in which the solid content was adjusted to be 20% was obtained. Meanwhile, as the polyisocyanate compound to serve as the crosslinking agent (curing agent), a curing agent (b) in which an adduct-type hexamethylene diisocyanate was adjusted with methyl ethyl ketone such that the solid content became 75%, was obtained. To the above main agent (a), 15% of the above curing agent (b) was added, whereby a coating liquid was prepared.

The ultraviolet transmittance (wavelength: 355 nm) of the adhesive agent layer and the protective layer was obtained by measuring a linear transmission component using a visible and ultraviolet spectrometer (UV3600 manufactured by SHIMADZU CORPORATION).

In Example 3, an adhesive agent in which only the content of the UV absorber A in the epoxy adhesive agent of Example 1 was changed so that the ultraviolet transmittance (wavelength: 355 nm) of the adhesive agent layer became the value shown in Table 1, was used. In each of Example 4 and Comparative Example 1, an adhesive agent in which only the content of the UV absorber B in the urethane adhesive agent of Example 2 was changed so that the ultraviolet transmittance (wavelength: 355 nm) of the adhesive agent layer became the value shown in Table 1, was used.

Adhesive agent coating: Coating was performed on a corona-treated surface of the PET film or the PEN film by a bar coater. The adhesive agent layer was adjusted so as to have a thickness of about 50 µm.

Cutting test: A cutting test was performed using a YAG third harmonic pulse laser having a wavelength of 355 nm. The laser apparatus was one manufactured by Takei Electric Industries Co., Ltd. The oscillator was a nanolaser manufactured by Spectra-Physics, Inc. Cutting was performed from the protective layer side under conditions of pulse frequency 100 kHz, 3 W.

As shown in FIG. 2(b), the portion irradiated with laser light was the third region 20 for dividing the device into the elements, and the third region was composed of the substrate, the adhesive agent layer, and the protective layer.

Cutting characteristic appearance: As the appearance of the cut portion, a case where 1 mm or more of darkening due to a smear was visually confirmed was indicated as poor, and a case where such darkening was not visually confirmed was indicated as good. The results are shown in Table 1.

Deterioration width: The cut end was observed with a microscope, and an average width of the portions of peeling off and darkening due to a smear inside the laminate was defined as a deterioration width. The results are shown in Table 1.

Storage characteristics: The device was stored in a room having a temperature of about 15°C to 25°C in ambient air for one month, and power generation characteristics of the device before and after the storage were evaluated. A case where reduction of 10% or higher was observed was indicated as poor, and a case where reduction of 5% or lower was observed was indicated as good. The results are shown in Table 1.

**[Table 1]**

| | Adhesive agent | Ultraviolet absorber | Adhesive agent layer | Protective layer | Protective layer | Substrate | Cutting characteristic appearance | Deterioration width | Storage characteristics |
|---|---|---|---|---|---|---|---|---|---|
| | | | Ultraviolet transmittance (%) | | Ultraviolet transmittance (%) | | | | |
| | | | | | | | | µm | |
| Example 1 | Epoxy adhesive agent | UV absorber A | 15 | PET | 12 | Glass | Good | *50* | Good |
| Example 2 | Urethane adhesive agent | UV absorber B | 13 | PEN | 10 | Glass | Good | 65 | Good |
| Example 3 | Epoxy adhesive agent | UV absorber A | 27 | PET | 21 | Glass | Good | 45 | Good |
| Example 4 | Urethane adhesive agent | UV absorber B | 14 | PEN | 11 | Glass | Good | 60 | Good |
| Comparative Example 1 | Urethane adhesive agent | UV absorber B | 65 | PET | 51 | Glass | Poor | 510 | Poor |

Even when a 50-µm thick UV-absorption-type PET film (HB3 manufactured by TOYOBO Co., Ltd., ultraviolet transmittance of 1%) was used as a substrate film, results similar to those in Examples were shown, cutting appearance was good, the deterioration width was at a level equivalent to those in Examples, and the storage characteristics were good.

Even when the film forming condition of the protective layer was changed such that the protective layer of ultraviolet transmittance was 60% and the others were the same as those in Examples 1 to 4, results similar to those in Examples 1 to 4 were shown, the cutting appearance was good, the deterioration width was at a level equivalent to those in Examples, and the storage characteristics were good.

### DESCRIPTION OF THE REFERENCE CHARACTERS

- 10, 100 :: device
- 11 :: protective layer
- 12 :: transparent electrically-conductive layer
- 13 :: electrically-conductive layer
- 14:: substrate
- 15 :: adhesive agent layer
- 16 :: electron transport layer
- 17 :: active layer
- 18 :: hole transport layer
- 20 :: third region
- A :: first region
- B :: second region
- C :: fourth region
- D :: fifth region

## Claims

1. A device comprising a substrate, a protective layer, an adhesive agent layer interposed between the substrate and the protective layer, wherein the adhesive agent layer is located on the protective layer, and
the adhesive agent layer has an ultraviolet transmittance of 30% or less at a wavelength of 355 nm.

2. The device according to claim 1, wherein the protective layer has an ultraviolet transmittance of 70% or less at a wavelength of 355 nm.

3. The device according to claim 1, wherein the difference between the ultraviolet transmittance of the adhesive agent layer and the ultraviolet transmittance of the protective layer is 13% or less.

4. The device according to claim 1, wherein the adhesive agent layer comprises at least one selected from an epoxy adhesive and a urethane adhesive.

5. The device according to claim 4, wherein the adhesive agent layer is an adhesive agent layer which is curable at room temperature or by heat.

6. The device according to any one of claims 1 to 5, wherein the adhesive agent layer further comprises an ultraviolet absorber.

7. The device according to any one of claims 1 to 5, wherein the device is for cutting with ultraviolet light.

8. A method for manufacturing a device, comprising steps of:
forming a structure body comprising a substrate, a first laminated body on a first region of the substrate, and a second laminated body on a second region different from the first region of the substrate,
adhering a protective layer arranged with an adhesive agent layer having an ultraviolet transmittance of 30% or less at a wavelength of 355 nm over the structure body of the first laminated body and the second laminated body through the adhesive agent layer, and
irradiating ultraviolet light into a third region between the first laminated body and the second laminated body of the structure body to melt a portion present in the third region of the substrate, the adhesive agent layer, and the protective layer.

9. The method for manufacturing the device according to claim 8, wherein the first laminated body includes a first electron transport layer, a first hole transport layer, and a first active layer between the first electron transport layer and the first hole transport layer, and the second laminated body includes a second electron transport layer, a second hole transport layer, and a second active layer between the second electron transport layer and the second hole transport layer.

10. The method for manufacturing the device according to claim 8, wherein the substrate is in contact with the adhesive agent layer in the third region.
